# EUROPEAN PATENT APPLICATION

(11) **EP 4 576 222 A1**
(43) Date of publication of application: **25.06.2025**
(21) Application number: 23219380.5
(22) Date of filing: 21.12.2023
(51) Int. Cl.: H01L 29/06, H01L 29/872, H01L 29/16, H01L 29/78

(54) **SEMICONDUCTOR POWER DEVICE WITH TERMINATION RINGS**

(71) Applicant: Nexperia B.V., 6534 AB Nijmegen (NL)
(72) Inventor: EL-ZAMMAR, Georgio, Hamburg (DE); BÖTTCHER, Tim, 22529 Hamburg (DE); MAZZILLO, Massimo Cataldo, Munich (DE); HABENICHT, Sönke, 22529 Hamburg (DE)
(74) Representative: Pjanovic, Ilija

(57) **Abstract**

Aspects of the present disclosure relate to a semiconductor power device, in particular to a Silicon Carbide, SiC, Merged P-I-N Schottky, MPS, diode. The semiconductor power device comprises a semiconductor body including a semiconductor substrate and an epitaxial layer formed on the semiconductor substrate, wherein an active area and a termination area adjacent the active area are arranged in the epitaxial layer. The termination area comprises a plurality of first rings of a first polarity, and a plurality of second rings of a second polarity different from the first polarity. The semiconductor substrate and the epitaxial layer are of the second polarity, and wherein a dopant concentration in the epitaxial layer associated with the second polarity is smaller than a dopant concentration in the second rings associated with the second polarity. The termination area comprises a first portion directly adjacent to the active area, and a second portion spaced apart from the active area by the first portion, and wherein the plurality of first rings and the plurality of second rings are arranged in the second portion.

## Description

### FIELD

Aspects of the present disclosure generally relate to a semiconductor power device, in particular to a Silicon Carbide, SiC, Merged P-I-N Schottky, MPS, diode.

### BACKGROUND

High voltage power semiconductor devices in general and Silicon Carbide (SiC) products in particular use many structures surrounding the active area. Jointly, these structures are referred to as termination area. It is of utmost importance for these devices to design a robust termination area able to withstand high voltages in the kV range. The main role of the termination area is to spread the potential lines in a manner to avoid crowding at particular regions of the termination area. Consequently, the termination area helps reducing the electric field at the edge of the active area, and when well designed, the termination area spreads equally the field across all the elements of the termination area avoiding any extreme field crowding at weak spots.

Weak spots or areas can be caused by design issues, e.g. unoptimized dimensions, process variation, e.g. lithography misalignment, ion implantation and diffusion, e.g. dose, energy and activation temperature, as well as interface charges caused by the presence of a passivation in the termination area. When using a nitride-based passivation, these charges are "positive", meaning ionized acceptors will accumulate in the semiconductor body at the termination area in order to compensate the holes trapped at the interface. The impact of passivation charges can be crucial. It results in an undesired depletion region at 0V that reduces the effectivity of the termination area causing low or unstable reverse blocking capability, poor unclamped inductive switching ruggedness, high temperature and high-voltage reliability failures, and limits fields of application for such a product.

In known termination areas the impact of passivation charges is always visible. An example of a termination area uses the concept of p-doped rings implemented in an n-doped semiconductor substrate. The width and distance of these p-dopes rings increase when the distance to the active area increases, e.g. towards the end of the semiconductor device or saw lane. These rings are also known as floating guard rings or Kao rings. These rings can be coupled with a large, lowly doped p-type area called junction termination extension border.

### SUMMARY

A summary of aspects of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

According to an aspect of the present disclosure, a semiconductor power device is provided that comprises a semiconductor body including a semiconductor substrate and an epitaxial layer formed on the semiconductor substrate. An active area and a termination area adjacent the active area are arranged in the epitaxial layer. The termination area comprises a plurality of first rings of a first polarity, and a plurality of second rings of a second polarity different from the first polarity. The first rings may be referred to as the abovementioned floating guard rings. The semiconductor substrate and the epitaxial layer have the second polarity. A dopant concentration in the epitaxial layer associated with the second polarity is smaller than a dopant concentration in the second rings associated with the second polarity. Furthermore, the termination area includes a first portion directly adjacent to the active area, and a second portion spaced apart from the active area by the first portion, and wherein the plurality of first rings and the plurality of second rings are arranged in the second portion.

The Applicant has found that by including the second rings having the second polarity a reduced effect of the abovementioned surface charges on the performance of the semiconductor power device can be observed. Furthermore, by including the second rings, a controlled depletion region between the first rings can be obtained that renders the semiconductor power device less sensitive to process variation for example variation in lithography or ion implantation.

Moreover, the Applicant has found that, by arranging the plurality of first and second rings in a region spaced apart from the active area (i.e., in the second portion, which is spaced apart from the active area by the first portion), the manufacturing process for the termination area can be more easily separated from that of the active area without or with limited effect on the performance of the semiconductor power device. For example, the plurality of first rings and the plurality of second rings can be formed relatively independently of the various components and regions corresponding to the active area and less dependent on alignment with the active area.

The first portion may be directly adjacent to a closest first ring among the plurality of first rings that is closest to the active area. In a further embodiment, a closest second ring among the plurality of second rings that is closest to the active area may be spaced apart from the first portion by the closest first ring.

A width of the first portion may be equal to or greater than a width of each of the plurality of first rings and/or a width of each of the plurality of second rings.

The plurality of first rings may extend farther towards the semiconductor substrate than the plurality of second rings. For example, the first and second rings may extend from an upper surface of the semiconductor body towards the semiconductor substrate. A depth along which the first rings extend into the semiconductor body typically lies in a range between 200 and 300 nanometer, and a depth along which the second rings extend into the semiconductor body typically lies in a range between 50 and 150 nanometer. In an embodiment, the first rings extend into the semiconductor body beyond the second rings. For example, the first rings extend more than 100 nanometer beyond the second rings, preferably more than 150 nanometer, more preferably more than 200 nanometer. Alternatively, the first rings may extend more than 100 percent beyond the second rings, preferably more than 150 percent, more preferably more than 200 percent.

The dopant concentration in the second rings associated with the second polarity can be at least 100 times larger than the dopant concentration in the epitaxial layer associated with the second polarity, preferably at least 1000 times larger, and more preferably at least 10000 times larger. As an example, the dopant concentration in the second rings associated with the second polarity may lie in range between 1E19 and 1E20 #/cm3.

The first rings and second rings can be alternatingly arranged. Additionally or alternatively, the first and second rings can be configured to be electrically floating during operation.

A dopant concentration in the first portion may be substantially identical to the dopant concentration of the epitaxial layer associated with the second polarity. In other words, the first portion may be substantially occupied by the epitaxial layer and not by any of the intentionally doped regions discussed above.

The termination area may further comprise a junction termination extension, JTE, border of the first polarity type, wherein the first and second rings are arranged inside the junction termination extension border. A dopant concentration of the JTE border associated with the first polarity can be 20 times smaller than a dopant concentration of the first rings associated with the first polarity, preferably 50 times smaller, more preferably 100 times smaller. For example, the dopant concentration of the first rings associated with the first polarity may lie in a range between 1E19 and 1E20 #/cm3, and the dopant concentration of the JTE border associated with the first polarity may lie in a range between 1E17 and 1E20 #/cm3. In a preferred embodiment, the JTE border may extend from the active area in the first portion and into part of the second portion.

The termination area may further comprise a plurality of floating JTE rings of the first polarity arranged spaced apart from the first and second rings, and spaced apart from, in so far as applicable, the abovementioned JTE border. A dopant concentration of the floating JTE rings associated with the first polarity may lie in a range between 1E17 and 1E18 #/cm3.

The termination area can be at least partially covered by a passivation layer. The passivation layer may comprise a passivation layer made of Silicon Nitride, Silicon Oxynitride, Silicon Oxide or Metallic Oxides. Additionally or alternatively, the passivation layer may comprise a field oxide for example made of Silicon Oxide. When the passivation layer comprises a field oxide, the field oxide may cover the termination area substantially in its entirety and optionally also part of the active area. This field oxide may be covered by other passivation layers, such as one or more of the layers mentioned above. When the passivation layer does not comprise the field oxide, the passivation layer may cover the termination area only partially.

The semiconductor power device may further comprise a channel stopper arranged at or near an edge of the semiconductor power device, wherein the termination area is arranged in between the channel stopper and the active area, and wherein the channel stopper is of the second polarity. A dopant concentration of the channel stopper associated with the second polarity may lie in a range between 1E18 and 1E20 #/cm3.

The abovementioned passivation layer may extend over the termination area from a region directly above the channel stopper towards the active area thereby covering at least part of the plurality of first and second rings. For example, at least 90 percent of the first and second rings may be covered, preferably at least 95 percent, and more preferably at least 98 percent.

The abovementioned field oxide may extend over the termination area from a region directly above the channel stopper towards the active area thereby fully covering the plurality of first and second rings.

The semiconductor power device may comprise a Merged P-I-N Schottky, MPS, diode. Other semiconductor power devices include but are not limited to metal-oxide-semiconductor field-effect transistors, 'MOSFETs', junction FETs, 'JFETs', Schottky barriers, and PN diodes.

With respect to the MPS diode, the active area comprises a conductive layer assembly comprising one or more conductive layers, such as a metal layers, and a plurality of mutually separated islands of the first polarity arranged in a current distribution layer of the second polarity. The conductive layer assembly forms Schottky contacts with the current distribution layer, and the conductive layer assembly forms Ohmic contacts with the plurality of islands of the first polarity. In some embodiments, an Ohmic contact is formed with a different metal or conductive layer than the Schottky contact. The combination of these different metal or conductive layers is referred to as conductive layer assembly. In addition, the conductive layer assembly may comprise relatively thick metal layers for providing low Ohmic resistance, especially when handling high currents.

Furthermore, the conductive layer assembly may form a first contact of the MPS diode, and the MPS diode may comprise a second contact arranged on the semiconductor substrate.

The current distribution layer can be formed by a well of the second polarity formed in the epitaxial layer, wherein a dopant concentration of the current distribution layer associated with the second polarity is at least 2 times larger than a dopant concentration of the epitaxial layer associated with the second polarity, preferably at least 3 times larger, more preferably at least 5 times larger.

The semiconductor substrate may comprise a Silicon Carbide substrate. However, the present disclosure equally relates to Silicon substrates, II-VI semiconductor material substrates, or III-V semiconductor material substrates such as GaN or AlGaN substrates.

The first polarity may correspond to p-type and the second polarity to n-type.

### BRIEF DESCRIPTION OF THE DRAWINGS

Next, the present disclosure will be described in more detail with reference to the appended drawings, wherein:
FIG. 1 is a general top view of a semiconductor power device;
FIG. 2 is a cross-sectional view of a semiconductor power device in accordance with an embodiment of the present disclosure; and
FIG. 3 is an enlarged view of part of the cross-section of FIG. 2; and
FIG. 4 is a cross-sectional view of a semiconductor power device in accordance with another aspect of the present disclosure.

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

### DETAILED DESCRIPTION

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the detailed description using the singular or plural number may also include the plural or singular number respectively. The word "or," in reference to a list of two or more items, covers all of the following interpretations of the word: any of the items in the list, all of the items in the list, and any combination of the items in the list.

The teachings of the technology provided herein can be applied to other systems, not necessarily the system described below. The elements and acts of the various examples described below can be combined to provide further implementations of the technology. Some alternative implementations of the technology may include not only additional elements to those implementations noted below, but also may include fewer elements.

These and other changes can be made to the technology in light of the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the detailed description section explicitly defines such terms. Accordingly, the actual scope of the technology encompasses not only the disclosed examples, but also all equivalent ways of practicing or implementing the technology under the claims.

To reduce the number of claims, certain aspects of the technology are presented below in certain claim forms, but the applicant contemplates the various aspects of the technology in any number of claim forms.

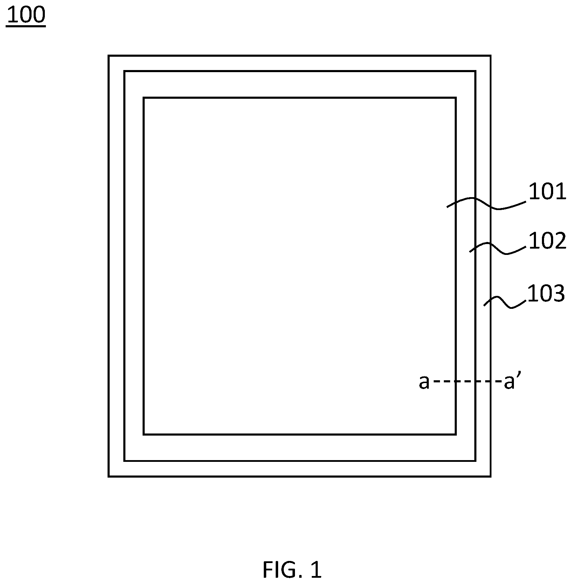

In FIG. 1, a general top view of a semiconductor power device 100 is shown that comprises an active area 101 in which a semiconductor device is realized, a termination area 102 adjacent to active area 101, and a channel stopper 103. Typically, semiconductor power device 100 is made from a semiconductor wafer on which a plurality of devices 100 are simultaneously formed. Channel stopper 103 may, prior to separating the devices, comprise structures, such as a saw lane, that allow the devices to be separated. Another structure that is or could be present in or on top of channel stopper 103 is a part of the passivation layer.

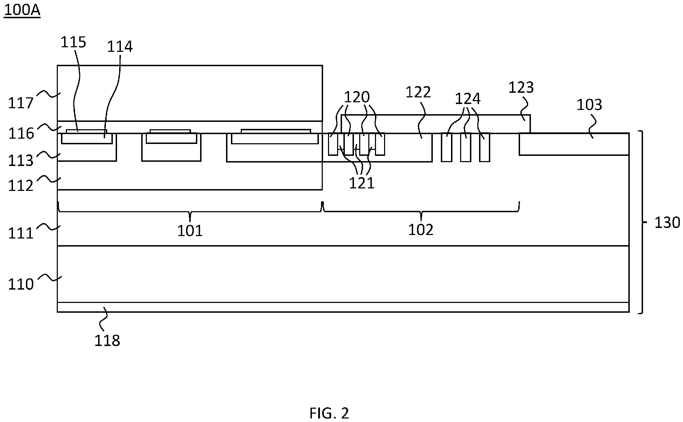

In FIG. 2, a cross-sectional view is provided that corresponds to the dashed line a-a' indicated in FIG. 1. Here, it is noted that those figures present an exemplary embodiment of a semiconductor power device in the form of a SiC MPS diode. However, the present disclosure is not limited thereto and aspects of the present disclosure could equally be applied to other semiconductor power devices such as metal-oxide-semiconductor field-effect transistors (MOSFETs), junction FETs (JFETs), Schottky barriers, or PN diodes, realized on different semiconductor material technologies such as Si, GaN, AlGaN and other II-VI or III-V semiconductor materials.

Now referring to FIG. 2, MPS diode 100A comprises a semiconductor body 130 comprising an n-type SiC substrate 110 on which an n-type SiC epitaxial layer 111 has been grown. Typical dopant concentrations in these layers are 1E19 #/cm3 and 1E16 #/cm3, respectively. Inside epitaxial layer 111, an n-type current spreader 112 with a typical dopant concentration of 5E16 #/cm3 has been formed using ion implantation. In turn, inside current spreader 112, a plurality of p-type wells 113 have been formed using ion implantation. Inside wells 113, highly doped p-type contact regions 114 have been formed using ion implantation to allow low-Ohmic contact resistance with a NiSi conductive layer 115. Typical dopant concentrations for wells 113 and contact region 114 are 1E18 #/cm3 and 1E20 #/cm3, respectively.

MPS diode 100A further comprises a Ti/TiN layer 116 covering the top surface of current spreader 112 and NiSi layer 115. At the regions where layer 116 contacts current spreader 112, i.e. in between wells 113, a Schottky contact is formed, whereas the NiSi layer 115 forms an Ohmic contact with contact region 114. Ti/TiN layer 116 is covered by a relatively thick AlCu layer 117 that forms a first contact terminal of MPS diode 100A. NiSi layer 115, Ti/TIN layer 116, and AlCu layer 117 may jointly be referred to as conductive layer assembly or conductive layer stack. Furthermore, a second contact terminal of MPS diode 100A is formed at a backside of SiC substrate 110.

Termination area 102 comprises a plurality of p-type first rings 120 having a typical dopant concentration of 1E20 #/cm3. In between p-type first rings 120, a plurality of n-type second rings 121 are arranged that have atypical dopant concentration of 5E19 #/cm3. As shown, first rings 120 extend farther towards SiC substrate 110 than rings 121. For example, a depth of first rings 120 equals 0.3 micrometer, whereas a height of second rings 121 equals 0.15 micrometer.

First rings 120 and second rings 121 may be arranged using ion-implantation separately from the ion-implantation steps for regions 112 - 114. More in particular, in the manufacturing process, separate implantation steps may be performed for regions in termination area 102 compared to regions in active area 101.

Both first and second rings 120, 121 are provided inside a p-type JTE border 122 having a typical dopant concentration of 5E17 #/cm3. Adjacent to JTE border 122, a plurality of p-type JTE rings 124 are arranged that have a typical dopant concentration of 5E17 #/cm3.

Although FIG. 2 illustrates an embodiment including four first rings 120 and three second rings 121, the present disclosure is not limited thereto, and more or less first rings 120, second rings 121, and/or JTE rings 124 than shown in FIG. 2 are equally envisaged.

In between channel stopper 103 and active area 101, a passivation layer 123 is provided that is made of Silicon Nitride, Silicon Oxynitride, Silicon Oxide, Metallic Oxide or a suitable combination thereof. As shown, passivation layer 123 does not extend over the entire surface between channel stopper 103 and active area 101.

Rings 120, 121, 124 are generally electrically floating during operation.

FIG. 2 presents several structures inside termination area 102. More in particular, in the embodiment shown in FIG. 2, MPS diode 100A comprises first rings 120, second rings 121, JTE border 122, and JTE rings 124. Among these structures, JTE border 122 and JTE rings 124 are optional. Several different embodiments are therefore possible according to aspects of the present disclosure as outlined in the list below:
Embodiment 1: rings 120, rings 121, JTE border 122, JTE rings 124 (as shown in FIG. 2)
Embodiment 2: rings 120, rings 121
Embodiment 3: rings 120, rings 121, JTE border 122
Embodiment 4: rings 120, rings 121, JTE rings 124
The list above indicates which structures are possible in the various different embodiments.

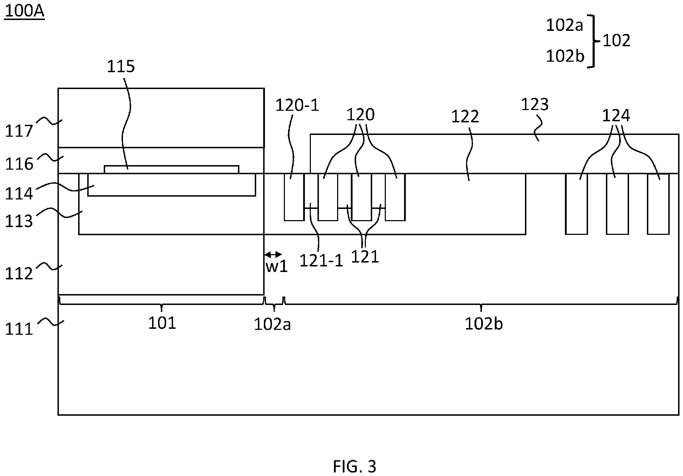

FIG. 3 illustrates an enlarged view of part of the cross-section shown in FIG. 2. In particular, as shown in FIG. 3, termination area 102 includes a first portion 102a directly adjacent to active area 101, and a second portion 102b spaced apart from active area 101 by first portion 102a. First rings 120 and second rings 121 are arranged in the second portion, and are therefore all spaced apart from active area 101.

First portion 102a may have a width w1, taken in an outward direction with respect to active area 101. Said width w 1 may be equal to or greater than a width of first rings 120 and/or second rings 121, taken in the same direction. For example, width w1 may be about 0.5 micrometer, a width of each first ring 120 may be about 0.5 micrometer or greater, and a width of each second ring 121 may be about 0.5 micrometer. In particular, the width and mutual distance of first rings 120 and/or second rings 121 may increase as the distance to the active area increases, e.g., towards the end of semiconductor device 100 or the saw lane of the wafer.

As shown in FIG. 3, a closest first ring 120-1 among the plurality of first rings 120 is arranged closer to active area 101 than a closest second ring 121-1 among the plurality of second rings 121. Hence, closest first ring 120-1 is spaced apart from active area 101 by first portion 102a of termination area 102, whereas closest second ring 121-1 is spaced apart from active area 101 by first portion 102a as well as by closest first ring 120-1.

In the embodiments including JTE border 122 (i.e., embodiments 1 and 3 described above), first rings 120 and second rings 121 may be spaced apart from active area 101 by said JTE border 122. On the other hand, if JTE border 122 is omitted (i.e., embodiments 2 and 4 described above), epitaxial layer 111 may extend in first portion 102a between active area 101 and second portion 102b. In other words, the region between closest first ring 120-1 and active area 101 (in particular well 113) is then occupied by epitaxial layer 111.

Although not explicitly shown in FIG. 3, second portion 102b may extend from first portion 102a up to channel stopper 103 of FIG. 2. Hence, first rings 120, second rings 121, and, if applicable, JTE rings 124 may all be provided in second portion 102b. Furthermore, if applicable, JTE border 122 may extend through first portion 102a and into part of second portion 102b.

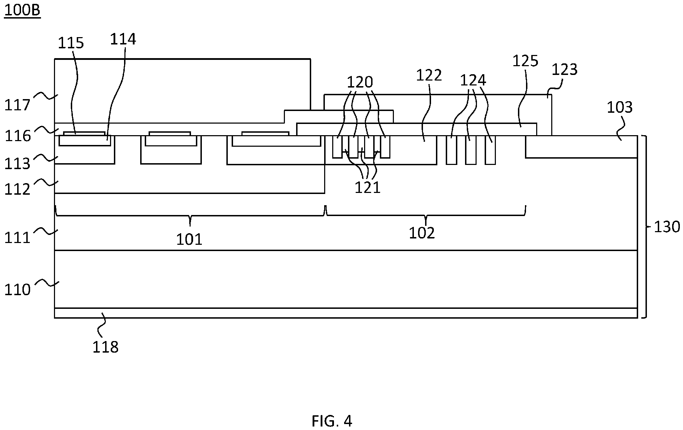

FIG. 4 illustrates a further MPS diode 100B that differs from MPS diode 100A of FIG. 2 and 3 in that a field oxide 125 made of Silicon Oxide is used as passivation layer instead of passivation layer 123 for directly contacting the top surface of semiconductor body 130. Contrary to passivation layer 123, field oxide 125 spans the entire surface between channel stopper 103 and active area 101. In addition, Ti/TiN layer 116 partially covers field oxide 125. In addition, a passivation layer 123 is arranged above part of Ti/TiN layer 116 and field oxide 125.

Remaining elements already described with reference to the embodiment shown in FIG. 2 may apply identically or similarly to the embodiment shown in FIG. 4, and a detailed description thereof is therefore omitted.

In the embodiments of FIG. 2 - 4, a separate conductive layer, i.e., NiSi layer 115, was used for realizing an Ohmic contact. In other embodiments, a same conductive layer, for example comprising one or more metal layers, may be used for simultaneously forming the Ohmic contact to p-type wells 113 and the Schottky contacts to current spreader 112.

The above description provides preferred exemplary embodiment(s) only, and is not intended to limit the scope, applicability or configuration of the present disclosure. Rather, the ensuing description of the preferred exemplary embodiment(s) will provide those skilled in the art with an enabling description for implementing a preferred exemplary embodiment of the present disclosure. Various changes may be made in the function and arrangement of elements, including combinations of features from different embodiments, without departing from the scope of the present disclosure as defined by the appended claims and, at least in some jurisdictions, their equivalents.

## Claims

1. A semiconductor power device, comprising:
a semiconductor body including a semiconductor substrate and an epitaxial layer formed on the semiconductor substrate, wherein an active area and a termination area adjacent the active area are arranged in the epitaxial layer,
wherein the termination area comprises a plurality of first rings of a first polarity, and a plurality of second rings of a second polarity different from the first polarity,
wherein the semiconductor substrate and the epitaxial layer are of the second polarity, and wherein a dopant concentration in the epitaxial layer associated with the second polarity is smaller than a dopant concentration in the second rings associated with the second polarity,
wherein the termination area includes a first portion directly adjacent to the active area, and a second portion spaced apart from the active area by the first portion, and wherein the plurality of first rings and the plurality of second rings are arranged in the second portion.

2. The semiconductor power device according to claim 1, wherein the first portion is directly adjacent to a closest first ring among the plurality of first rings that is closest to the active area.

3. The semiconductor power device according to claim 2, wherein a closest second ring among the plurality of second rings that is closest to the active area is spaced apart from the first portion by the closest first ring.

4. The semiconductor power device according to any of the previous claims, wherein a width of the first portion is equal to or greater than a width of each of the plurality of first rings and/or a width of each of the plurality of second rings.

5. The semiconductor power device according to any of the previous claims, wherein the plurality of first rings extends farther towards the semiconductor substrate than the plurality of second rings,
wherein the first rings preferably extend more than 100 nanometer beyond the second rings, more preferably more than 150 nanometer, and even more preferably more than 200 nanometer, and/or wherein the first rings preferably extend more than 100 percent beyond the second rings, more preferably more than 150 percent, and even more preferably more than 200 percent.

6. The semiconductor power device according to any of the previous claims, wherein the dopant concentration in the second rings associated with the second polarity is at least 100 times larger than the dopant concentration in the epitaxial layer associated with the second polarity, preferably at least 1000 times larger, and more preferably at least 10000 times larger.

7. The semiconductor power device according to any of the previous claims, wherein the first rings and second rings are alternatingly arranged.

8. The semiconductor power device according to any of the previous claims, wherein the first and second rings are configured to be electrically floating during operation.

9. The semiconductor power device according to any of the previous claims, wherein a dopant concentration in the first portion is substantially identical to the dopant concentration of the epitaxial layer associated with the second polarity.

10. The semiconductor power device according to any of the claims 1-8, wherein the termination area further comprises a junction termination extension, JTE, border of the first polarity type, wherein the first and second rings are arranged inside the junction termination extension border,
wherein, preferably, a dopant concentration of the JTE border associated with the first polarity is 20 times smaller than a dopant concentration of the first rings associated with the first polarity, more preferably 50 times smaller, even more preferably 100 times smaller,
wherein, more preferably, the JTE border extends from the active area in the first portion and into part of the second portion.

11. The semiconductor power device according to any of the previous claims, wherein the termination area further comprises a plurality of floating JTE rings of the first polarity arranged spaced apart from the first and second rings, and spaced apart from, in so far as depending on claim 10, the JTE border.

12. The semiconductor power device according to any of the previous claims, wherein the termination area is at least partially covered by a passivation layer;
wherein the passivation layer preferably comprises a passivation layer made of Silicon Nitride, Silicon Oxynitride, Silicon Oxide or a Metallic Oxide; and/or
wherein the passivation layer preferably comprises a field oxide, preferably made of Silicon Oxide,
wherein the semiconductor power device preferably further comprises a channel stopper arranged at or near an edge of the semiconductor power device, wherein the termination area is arranged in between the channel stopper and the active area, and wherein the channel stopper is of the second polarity,
wherein, more preferably:
when the passivation layer comprises a passivation layer made of Silicon Nitride, Silicon Oxynitride, Silicon Oxide or Metallic Oxide, it extends over the termination area from a region directly above the channel stopper towards the active area thereby covering a part of the plurality of first and second rings; or
when the passivation layer comprises the field oxide, it extends over the termination area from a region directly above the channel stopper towards the active area thereby fully covering the plurality of first and second rings.

13. The semiconductor power device according to any of the previous claims, wherein the semiconductor power device comprises a Merged P-I-N Schottky, 'MPS', diode, a metal-oxide-semiconductor field-effect transistor, 'MOSFET', a junction FET, 'JFET', a Schottky barrier, or a PN diode.

14. The semiconductor power device according to claim 13, wherein the semiconductor power device comprises a MPS diode, and wherein the active area comprises:
a conductive layer assembly comprising one or more conductive layers, such as a metal layers; and
a plurality of mutually separated islands of the first polarity arranged in a current distribution layer of the second polarity,
wherein the conductive layer assembly forms Schottky contacts with the current distribution layer and Ohmic contacts with the plurality of islands of the first polarity,
wherein the conductive layer assembly forms a first contact of the MPS diode, and wherein the MPS diode comprises a second contact arranged on the semiconductor substrate,
wherein, preferably, the current distribution layer is formed by a well of the second polarity formed in the epitaxial layer and wherein a dopant concentration of the current distribution layer associated with the second polarity is at least 2 times larger than a dopant concentration of the epitaxial layer associated with the second polarity, more preferably at least 3 times larger, even more preferably at least 5 times larger.

15. The semiconductor power device according to any of the previous claims, wherein the semiconductor substrate comprises a Silicon Carbide substrate; and/or
wherein the first polarity corresponds to p-type and the second polarity to n-type.
